# EUROPEAN PATENT APPLICATION

(11) **EP 0 593 198 A2**
(43) Date of publication of application: **20.04.1994**
(21) Application number: 93307936.0
(22) Date of filing: 06.10.1993
(51) Int. Cl.: G01R 31/36, H04Q 7/02

(54) **Apparatus and method for displaying remaining energy of a battery**

(30) Priority: 14.10.1992 JP 300606/92
(71) Applicant: MATSUSHITA ELECTRIC INDUSTRIAL CO., LTD., Kadoma-shi, Osaka-fu, 571 (JP)
(72) Inventor: Akiyama, Jun, Tokyo (JP)
(74) Representative: Sorrell, Terence Gordon

(57) **Abstract**

In a display system for displaying remaining power of a battery (6) of an appliance which operates by the battery (6), a period of time for which when the appliance is continued to operate on the basis of transmitting power and the like which is set at the time point of the display, the appliance can be continued to operate under the condition of the remaining power of the battery (6) is obtained by battery voltage measuring means (7), consumed current calculating means (9) and battery remaining time calculating means (10), and then the data relating thereto is displayed as remaining time of the battery (6) on display means (11). On the basis of the display of the remaining time of the battery (6), a user can become aware of a period of time for which the appliance can be continued to operate, judge suitably whether or not the operation of the appliance should be continued, and make properly sure of the time when the battery (6) should be charged.

## Description

### BACKGROUND OF THE INVENTION

### Field of the Invention

The present invention relates to an apparatus for displaying remaining power of a battery for use in an appliance which operates with a battery like a radio communication appliance such as a portable telephone and a method employing the same, and more particularly to a display apparatus for displaying remaining power of a battery which is designed so as to display data with respect to information intelligible to a user and a method employing the same.

### Description of the Related Art

In a portable telephone, the portable telephones and a base station are connected to each other through wireless lines, and the communication with the other party is performed through the base station.

In a digital portable telephone which operates to transmit signals by the time division multiplex, the transmission operation and the receiving operation are alternately performed by using the different radio frequencies, and the signal transmitted/received to/from the digital portable telephone of the other party is subjected to the digital processing in the digital portable telephone. The band width of 890 to 915 MHz can be used for the transmission frequency and the band width of 935 to 960 MHz can be used for the receiving frequency. Then, the RF channels are assigned to each of the transmission frequency and the receiving frequency with the adjacent channel interval of 200 kHz kept, and the eight speech channels are set in each of the RF channels by the time division.

Now, the RF transmission output of the portable telephone is set into the fourteen steps within the range of 20 mW to 8 W by an instruction which has been issued from the base station monitoring the receiving level.

Further, the portable telephone is provided with a rechargeable battery, such as the nikel-cadmium (Ni-Cd) battery, as the power source, and performs the desired operation using the electric power supplied from this battery. The prior art portable telephone is designed in such a way that for the purpose of informing the user of the remaining power of this battery, the data with respect to the remaining power is displayed on a display device in a hand set unit.

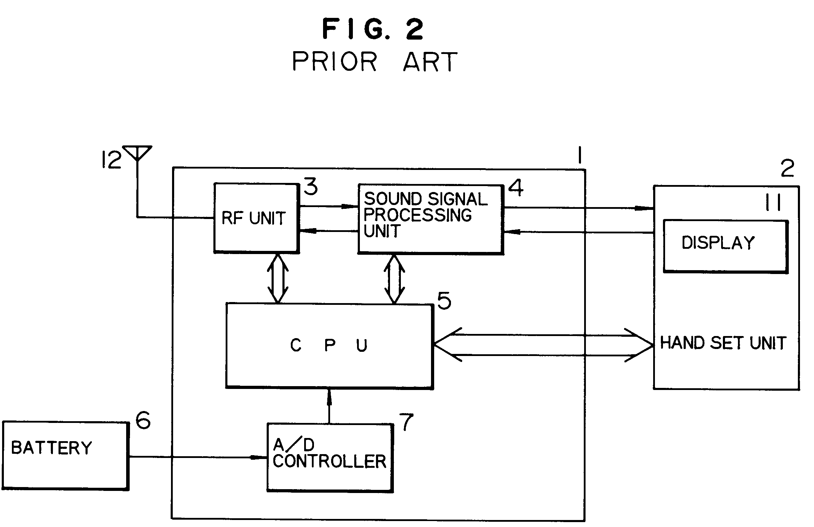

This portable telephone is, as shown in Fig. 2, constituted by a body unit 1 and a hand set unit 2 provided with a display device 11. In this connection, the body unit 1 includes, but is not limited to, an antenna 12, an RF unit 3 which operates to modulate/demodulate the transmission/receiving signal into a signal having a radio frequency, a sound signal processing unit 4 which operates to subject the sound signal to the digital processing, a battery 6 as a power source, an analog-to-digital (A/D) converter 7 which operates to convert a signal corresponding to the information of a voltage developed across terminals of the battery 6 into a digital signal, and a central processing unit (CPU) 5 which operates to control the operations of the whole apparatus.

In this portable telephone, the remaining power of the battery as the power source is displayed as follows.

The A/D converter 7 measures the voltage developed across the terminals of the battery 6 and then converts the measured value relating to the terminal voltage into the digital signal to transmit the digital signal to CPU 5. Then, CPU 5 sends directly the information transmitted thereto to the hand set unit 2 which displays, on the basis of the information received thereby, the information relating to the remaining power of the battery 6 on the display device 11 analogically or digitally.

However, in the prior art system for displaying remaining power of a battery, the remaining power of the battery such as the voltage developed across the terminals of the battery is only reported to the user. Therefore, the user is not taught how long the telephone call can be continued to be performed by the remaining power of the battery. For example, in the case where the remaining power of the battery such as the voltage of the battery, when the transmission output of the portable telephone is 20 mV, is the same as that when the transmission output of the portable telephone is 8 W, there occurs the remarkable difference therebetween with respect to the remaining period of time for which the user can perform the telephone call. However, in the prior art display system, the information on the basis of which such a difference is made clear for the user is not shown to the user.

### SUMMARY OF THE INVENTION

The present invention was made in order to solve the above-mentioned problem peculiar to the prior art display system and therefore an object of the present invention is to provide a display system for displaying information with respect to remaining power of a battery so as for a user to be easy to understand that information concretely.

Then, according to the present invention, in a system for displaying remaining power of a battery of a radio communication appliance and the like which are actuated by the battery, a period of time for which the operation of the appliance can be continued to be performed under the condition of the remaining power of the battery if the operation of the appliance will be continued to be performed on the basis of transmitting power and the like which has been set at the time point of display is displayed as remaining time of a battery.

Therefore, the user can become aware of how long the operation of the appliance can be continued to be performed on the basis of the display of the remaining time of the battery, and also can suitably judge whether or not the operation thereof should be continued to be performed, thereby to properly make sure of the time when the battery should be charged.

### BRIEF DESCRIPTION OF THE DRAWINGS

Fig. 1 is a block diagram showing a configuration of an embodiment of an apparatus for displaying remaining power of a battery and a method employing the same according to the present invention; and
Fig. 2 is a block diagram showing a configuration of the prior art apparatus for displaying remaining power of a battery.

### DESCRIPTION OF THE PREFERRED EMBODIMENTS

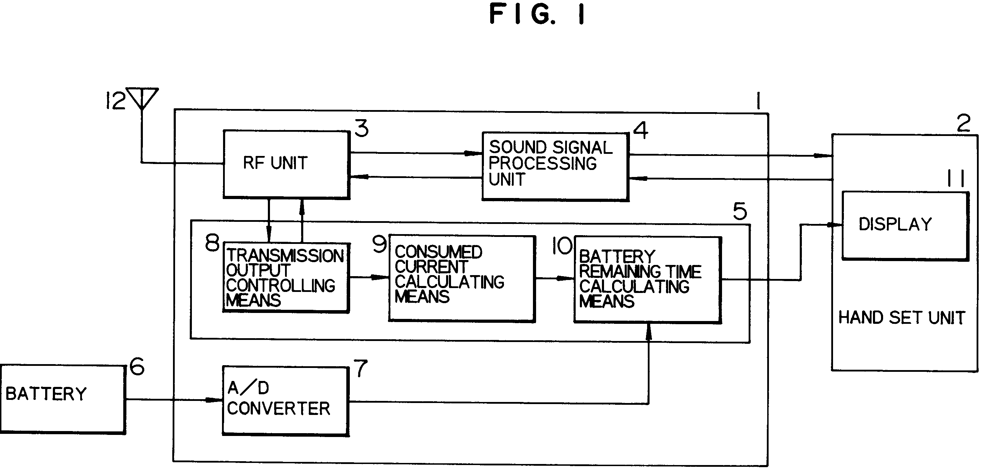

Fig. 1 shows a configuration of a portable telephone as an embodiment of an apparatus for displaying remaining power of a battery and a method employing the same according to the present invention. In this portable telephone, as the functional blocks relating to the display of the remaining power of a battery, CPU 5 of a body unit 1 includes, but is not limited to, means 9 for calculating a consumed current, which operates to convert the information relating to a transmission output supplied from means 8 for controlling a transmission output into the information relating to the consumed current, and means 10 for calculating remaining time of a battery, which operates to calculate a period of time for which a telephone call can be continued to be performed (telephone call possible time). The other constituent units of this portable telephone are the same as those of the prior art portable telephone, and therefore the description thereof is omitted here for the sake of simplicity.

In the portable telephone, in order to display the remaining time of the battery, the means and the units in the blocks operate as follows.

The transmission output controlling means 8 sets a transmission output in the RF unit 3 in accordance with an instruction which has been issued from the base station.

The consumed current calculating means 9 contains a memory table for storing the data relating to the correspondence relation between the transmission output and the consumed current therein. The means 9 receives the information relating to the transmission output at that time supplied from the transmission output controlling means 8 and then converts the information thus received into the information relating to the consumed current in accordance with the memory table to output the resultant information to the battery remaining time calculating means 10.

Further, the A/D converter 7 measures the voltage developed across the terminals of the battery 6 and then converts the terminal voltage thus measured into a digital signal to output the digital signal to the battery remaining time calculating means 10.

The battery remaining time calculating means 10 receives the information which has been supplied from both the consumed current calculating means 9 and the A/D converter 7 and then calculates the remaining quantity of electric charge in the battery on the basis of the terminal voltage of the battery and finally calculates the remaining telephone call possible period of time on the basis of both that calculation result and the consumed current.

The information relating to the telephone call possible period of time thus calculated is sent to the hand set unit 2 in which the display device 11 displays the data relating to the telephone call possible period of time digitally or analogically on the basis of the information thus sent thereto.

As described above, in the apparatus for displaying remaining power of a battery and the method employing the same according to the present invention, the data relating to the period of time is displayed for which in the case where the telephone call is continued to be performed under the condition of the transmission output which is already set, the telephone call can be continued to be performed, whereby the user is informed of the remaining power of the battery.

Incidentally, in the non-conversation by telephone, the transmission output controlling means 8 sends the information relating to the transmission output which was initially set or the transmission output which was set in the last telephone call to the consumed current calculating means 9. Then, on the basis of this information, the data relating to the telephone call possible period of time is displayed on the display device.

In addition, the display of the telephone call possible period of time may be performed together with the conventional display of the battery voltage, or one of them may be selectively performed.

All the information processings for carrying out the display system of the present invention may be performed in CPU 5 of the body unit 1, and in this case, there is no need for adding the constituent units to the apparatus in terms of the hardware.

Further, the data relating to the remaining power of the battery is not always necessarily displayed all the time. In other words, the apparatus for displaying remaining power of a battery according to the present invention may be designed in such a way that only when the user performs the monitoring operation, the display of the data relating to the remaining power of the battery is performed for a fixed period of time.

Incidentally, the apparatus for displaying remaining power of a battery and the method employing the same according to the present invention are not limited to the application to the digital portable telephone and thus are applicable to all the appliances which are actuated by the battery.

As apparent from the above-mentioned description of the embodiment, in the apparatus for displaying remaining power of a battery and the method employing the same according to the present invention, it is possible to inform concretely the user of the information relating to the period of time for which under the condition of the consumed current which is already set, the operation of the appliance can be continued to be performed. Therefore, even in the case where the remaining power of the battery is reduced, the user can cope suitably with such a case well in advance.

## Claims

1. An apparatus for obtaining remaining power of a battery (6) of an appliance, which is driven by said battery (6) to operate in a plurality of consumed current modes, to display data relating to the remaining power of said battery (6), comprising:
battery voltage measuring means (7) for measuring a voltage of said battery (6) to obtain a measured value of the battery voltage;
consumed current calculating means (9) having memory means and serving to read out, in correspondence to the consumed current mode of said appliance, a calculated value of a consumed current stored in said memory means;
battery remaining time calculating means (10) for calculating a period of time, for which said appliance can operate by said battery (6), on the basis of both the measured value of the battery voltage and the calculated value of the consumed current; and
display means (11) for displaying data relating to the calculation result provided by said battery remaining time calculating means (10).

2. An apparatus according to Claim 1, wherein said battery voltage measuring means (7) is composed of an A/D converter.

3. An apparatus according to Claim 1, wherein said appliance is composed of a radio communication appliance in which a transmission output can be changed, wherein said apparatus further comprises transmission output controlling means (8) for controlling the transmission output of said radio communication appliance and for outputting information relating to the transmission output to said consumed current calculating means (9), and wherein said consumed current calculating means (9) reads out the calculated value of the consumed current of said appliance on the basis of the information relating to the transmission output.

4. An apparatus according to Claim 3, wherein said transmission output controlling means (8) controls the transmission output of said radio communication appliance on the basis of an instruction issued from a base station.

5. A method of obtaining remaining power of a battery (6) of an appliance, which is driven by said battery (6) to operate in a plurality of consumed current modes, to display data relating to the remaining power of said battery (6), comprising the steps of:
measuring a voltage of said battery (6) to obtain a measured value of the battery voltage;
reading out, in correspondence to the consumed current mode of said appliance, a calculated value of the consumed current which is already stored;
calculating a period of time for which said appliance can operate by said battery (6) on the basis of both the measured value of the battery voltage and the calculated value of the consumed current, thereby to obtain remaining time of said battery (6); and
displaying data relating to the remaining time of said battery (6).

6. A method according to Claim 5, wherein said step of obtaining a measured value of said battery (6) is to convert the voltage of said battery (6) into a digital signal.

7. A method according to Claim 5, wherein said appliance is composed of a radio communication appliance in which a transmission output can be changed, wherein said method further comprises the step of controlling the transmission output of said radio communication appliance and of outputting information relating to the transmission output, and wherein said step of reading out a calculated value of the consumed current is to read out the calculated value of the consumed current of said appliance on the basis of the information relating to the transmission output.

8. A method according to Claim 7, wherein said step of controlling the transmission output is to control the transmission output of said radio communication appliance on the basis of an instruction issued from a base station.
